# EUROPEAN PATENT APPLICATION

(11) **EP 2 525 388 A2**
(43) Date of publication of application: **21.11.2012**
(21) Application number: 12168204.1
(22) Date of filing: 16.05.2012
(51) Int. Cl.: H01J 37/32

(54) **Large area ICP source for plasma application**

(30) Priority: 17.05.2011 US 201161487238 P
(71) Applicant: Intevac, Inc., Santa Clara, CA 95054 (US)
(72) Inventor: CHO, Young Kyu, San Jose, CA California 95120 (US); BLUCK, Terry, Santa Clara, CA California 95051 (US); JANAKIRAMAN, Karthik, San Jose, CA California 95138 (US)
(74) Representative: Kirschner, Klaus Dieter

(57) **Abstract**

In an arrangement for coupling RF energy for inductively coupled plasma chamber, a RF coil (515) or radiator is embedded within a groove (530) made in the ceiling of the chamber and an insulating filler (535, 540) covers the coil within the groove. The ceiling may be made of two plates: an upper plate (522)made of conductive material and a bottom plate (524) made of dielectric material. The two plates are in physical contact. A magnetic shield (545) may be provided over the coil to control the spread of the magnetic field from the coil. Fluid channels (570, 575) may be made in the conductive plate to provide thermal control. Also, fluid conduits (560) may be provided to allow injecting gas into the pace between the metal and dielectric plates.

## Description

This disclosure relates to inductively-coupled plasma (ICP) chambers and, more specifically, for ICP chambers having large area ceiling, such as those used for fabrication of flat panel display, solar cells, etc.

Inductively-coupled plasma chambers are well known in the art.

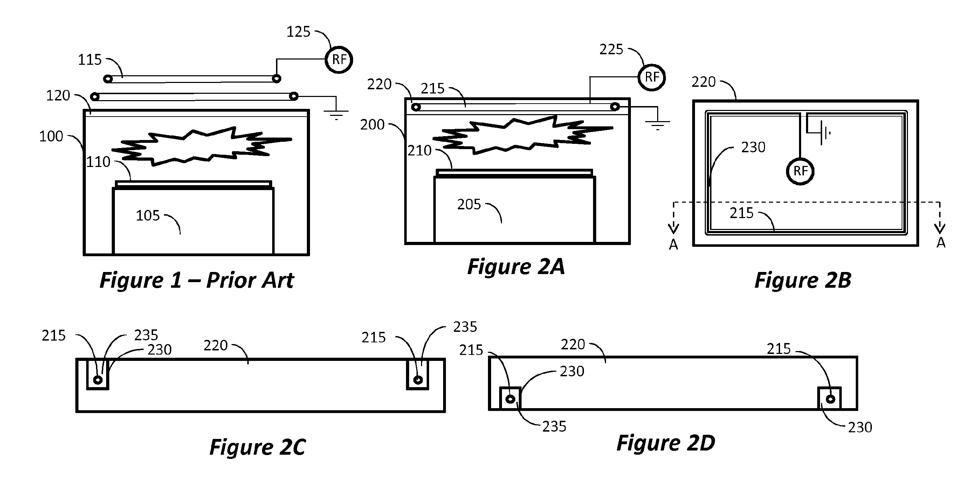

Fig. 1 illustrates a conventional design of an ICP chamber generally used for fabrication of integrated circuits in silicon wafers. A vacuum chamber 100 has a pedestal 105 placed therein to support the processed substrate 110. RF generator 125 is coupled to coil 115, which is placed above dielectric window 120. The dielectric window 120 basically serves as the ceiling of the vacuum chamber 100.

The prior art arrangement is workable for processing semiconductor substrates. However, when the substrate is larger than standard semiconductor wafer, e.g., a flat panel display substrate, or when several substrates are processed simultaneously inside the chamber, such as for solar cells, the size of the vacuum chamber is much larger. Consequently, the dielectric window ceiling needs to be larger. When the dielectric window becomes larger, it also needs to be thicker so as to withstand the atmospheric forces when vacuum is drawn inside the chamber. However, when the dielectric window is thicker, the coil is farther from the processing substrate and the thick window causes inefficient coupling of the RF energy to sustain the plasma inside the chamber.

Accordingly, there's a need for an improved arrangement for ICP chamber, even for chambers having larger ceilings and coils.

The following summary is included in order to provide a basic understanding of some aspects and features of the disclosure. This summary is not an extensive overview of the invention and as such it is not intended to particularly identify key or critical elements of the invention or to delineate the scope of the invention. Its sole purpose is to present some concepts of the invention in a simplified form as a prelude to the more detailed description that is presented below.

Aspects of the invention provide an ICP arrangement that can be implemented for any size chamber and enables efficient coupling of the RF energy into the chamber for sustaining the plasma.

According to disclosed aspects, the RF coil is embedded inside the dielectric window. According to various embodiments, the RF coil is placed inside the vacuum chamber, but is not exposed to the plasma.

According to one embodiment, the dielectric window is formed substantially as a flat plate made of dielectric material. A groove is formed in the dielectric window, and the RF coil is inserted within the groove. Insulating filler is provided in order to seal the groove with the RF coil. The groove may be made on the upper side of the dielectric window, in which case the coil is in atmosphere, or it can be made on the bottom side of the plate, in which case the coil is in vacuum environment.

According to further embodiments, the dielectric window is formed substantially as a flat plate made of metal. A groove is formed in the metal plate, and the RF coil is inserted within the groove. A conductive cover is placed over the coil, such that it provides magnetic shielding above the coil, but enable magnetic field to emanate below the coil and maintain plasma inside the chamber. Insulating filler is provided to seal the groove with the RF coil and the cover. The filler can be provided between the coil and the shield, between the shield and the dielectric plate, or both. A dielectric plate is provided at the bottom of the conductive plate, so as to insulate the coil from the vacuum, but allow magnetic field into the chamber.

According to further embodiments, fluid channels may be provided in the conductive plate, so as to provide thermal control. Also, gas conduit may be provided to allow pumping of gas, such as argon or nitrogen, into the space between the metal plate and the dielectric plate, so as to generate positive pressure therebetween.

Other aspects and features of the invention would be apparent from the detailed description, which is made with reference to the following drawings. It should be appreciated that the detailed description and the drawings provides various non-limiting examples of various embodiments of the invention, which is defined by the appended claims.

The accompanying drawings, which are incorporated in and constitute a part of this specification, exemplify various embodiments and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements and are, therefore, not drawn to scale.

Further advantages, features and potential applications of the present invention may be gathered from the description which follows, in conjunction with the embodiments illustrated in the drawings.

Throughout the description, the claims and the drawings, those terms and associated reference signs will be used as are notable from the enclosed list of reference signs. In the drawings
- Fig. 1: illustrates a conventional design of an ICP chamber generally used for fabrication of integrated circuits in silicon wafers;
- Figs. 2A-2D: are schematic illustrations of an ICP chamber and dielectric ceiling and coil arrangements, according to disclosed embodiments;
- Fig. 3: illustrates another ceiling and coil arrangement according to one embodiment;
- Fig. 4: illustrates yet another ceiling and coil arrangement according to one embodiment;
- Fig. 5: illustrates two modifications, either or both of which may be made to the embodiments of Fig. 3 or Fig. 4, and
- Fig. 6: illustrates another embodiment, which is somewhat of a hybrid of the other embodiments disclosed.

A description will now be provided of various embodiments which enable efficient coupling of RF energy using an embedded coil. In some embodiments the RF coil is in atmospheric environment, while in others the coil is within the vacuum environment of the processing chamber.

Fig. 2A illustrates an embodiment of a processing chamber wherein an RF coil is embedded within the dielectric window, while Figs. 2B-C illustrate arrangements of the coil embedded within the ceiling, which forms a dielectric window. The numerical references in Figs. 2A-D relating to corresponding elements in Fig. 1 are the same, except that they are in the 2xx series. While not specifically shown, the chamber 200 of the embodiment of Fig. 2 may be much larger than that of Fig. 1, and may process one large substrate 210 or several smaller substrates 210. Consequently, ceiling 220 is larger than ceiling 120 and may be thicker as well. However, to position the coil 215 closer to the plasma, coil 215 is embedded within the dielectric Window.

Fig. 2B illustrates a top or bottom view (depending whether embodiment 2C or 2D is used) of the ceiling 220. A groove 230 is cut into the dielectric ceiling, which is substantially a dielectric plate, as can be seen in the cross section A-A of Figs. 2C and 2D. The coil 215 is inserted in the groove, and the groove is filled with insulating material, such as silicon or epoxy filling 235. According to the embodiment depicted in Fig. 2C the groove is formed on the top, i.e., exterior, surface of the ceiling, such that the coil is placed outside the vacuum chamber. Conversely, according to the embodiment of Fig. 2D the groove is formed on the bottom, i.e., interior, surface of the ceiling, such that the coil resides inside the vacuum environment of the chamber. In both embodiments, the bottom of the ceiling remains flat, such that the plasma still "sees" flat ceiling.

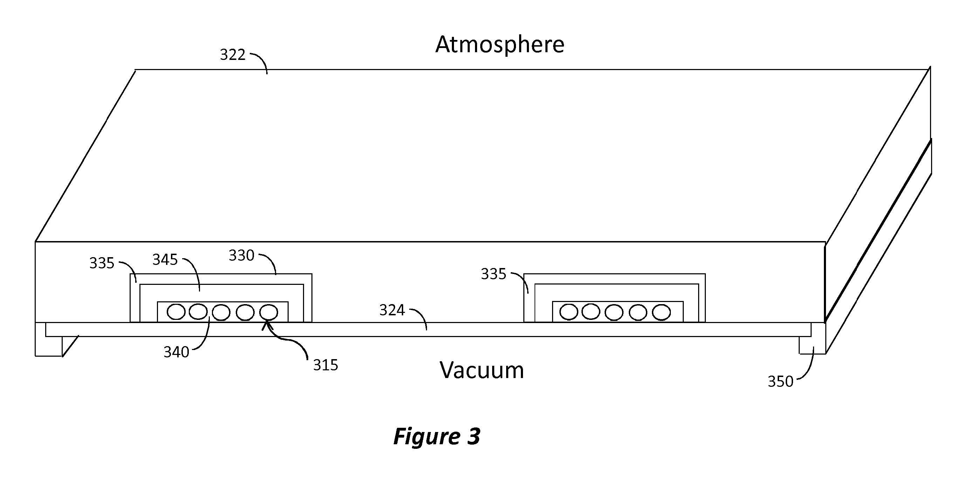

Fig. 3 illustrates another ceiling and coil arrangement that is especially beneficial for large processing chambers. Using the embodiment of Fig. 3, the dielectric window can be made thin regardless of the size of the ceiling. According to the embodiment of Fig. 3, the ceiling is made of a sandwich of metal backplate 322, e.g., aluminum, stainless steel, etc., and a dielectric window 324. The dielectric window 344 may be adhered to the backplate 322 or may be held using a bracket 350, or both. Otherwise, any method for holding the backplate 322 and dielectric window 322 can be used.

The groove 330 is made in the bottom part of the metal backplate. The coil 315 resides within the groove, and is covered by the dielectric window 324. Since the metal backplate 322 is sufficiently strong to overcome the atmospheric forces, the dielectric window 324 can be made thin.

According to one embodiment, the coil is suspended within the groove 330, and vacuum can be maintained inside the groove. However, using such an arrangement provides insufficient control over the magnetic field generated by the coil 315. Therefore, according to another embodiment, a magnetic field shaping cover 345 is provided between the coil 315 and the metal backplate 322. The cover 345 is made of ferrite material and may have a horseshoe cross-section or other shape as required to properly confine or shape the magnetic field, such that the RF energy is efficiently coupled to the plasma.

Using this arrangement RF energy can be efficiently coupled to the plasma, such that the coil 315 should not get too hot. However, if thermal control of the coil and/or the cover is needed, then the spacing between the coil 315 and cover 345 and/or the space between the cover 345 and the backplate 322, may be filled with insulating material 340 and 335, either of which may be a thermally conductive sealant.

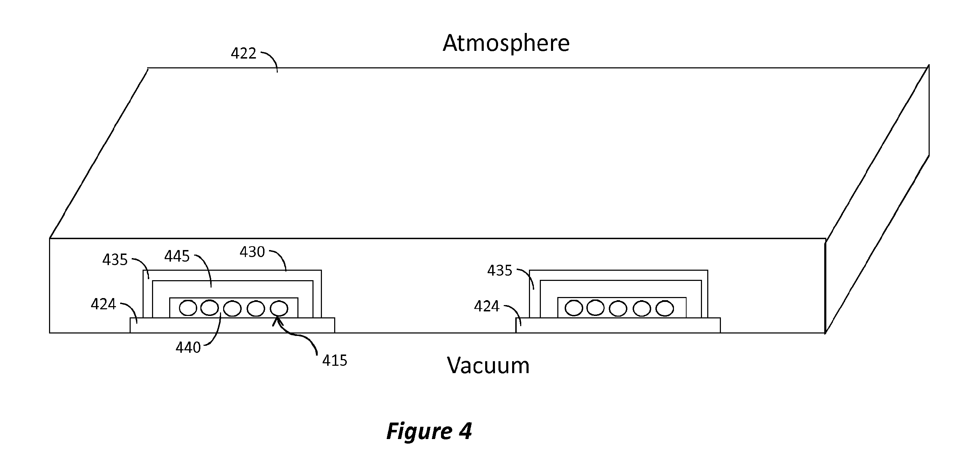

Fig. 4 illustrates yet another ceiling and coil arrangement according to one embodiment wherein the coil is placed on the vacuum side of the chamber. This arrangement enables efficient coupling of RF energy to the plasma, but does not require a large thick dielectric window regardless of the size of the chamber. According to this embodiment, the ceiling 422 is made of metallic material and includes coil and cover arrangement in a groove 430, just like that of Fig. 3. However, rather than having a large dielectric window attached to the bottom of the ceiling, small dielectric plates 424 are provided to cover only the groove 430.

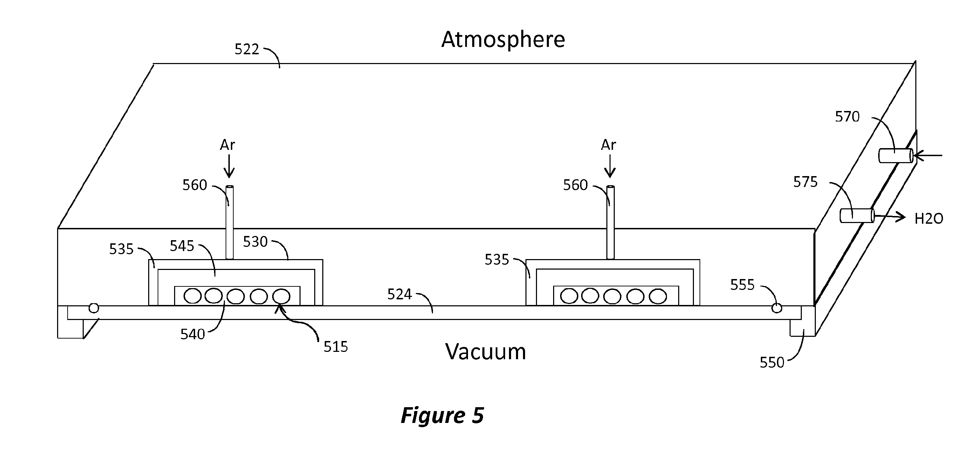

Fig. 5 illustrates two modifications, either of both of which may be made to the embodiment of Fig. 3; however, either or both modifications can also be made to the embodiments shown in Figs. 4. In the embodiment of Fig. 5, the backplate 522 is actively cooled. Specifically, fluid inlet 570 and outlet 575 are used to circulate cooling fluid in channels made inside backplate 522. The cooling fluid may be temperature controlled water.

Additionally, a seal 555, such as an o-ring, can be provided between the dielectric window 524 and backplate 522. An inlet 560 enables pumping gas, such as argon, into the space between the dielectric window and the backplate so as to create positive pressure with respect to the vacuum inside the processing chamber. This prevents processing gas from reaching into the space between the backplate 522 and window 524. The gas also help in thermal conduction from the coil 515 and cover 545 to the backplate 522. The gas conduit may be made so as to inject gas into the groove.

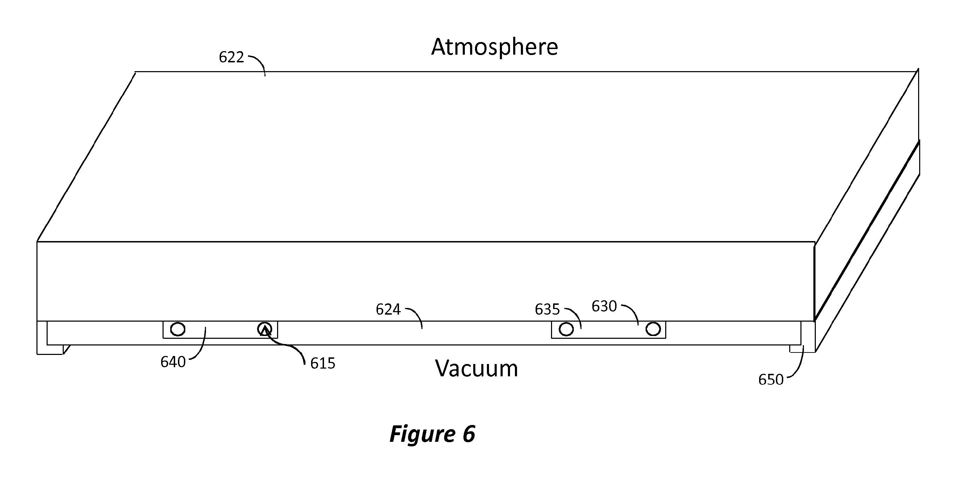

Fig. 6 illustrates another embodiment, which is somewhat of a hybrid of the other embodiments disclosed. The embodiment of Fig. 6 illustrates a chamber ceiling made of an upper metallic plate 622 which provides strength, and a bottom dielectric plate 624 which provides transparency for RF coupling.

A groove 630 is made in the upper part of the dielectric plate 624. The coil 615 resides within the groove, and is covered by the dielectric window 624. Since the metal backplate 622 is sufficiently strong to overcome the atmospheric forces, the dielectric window 624 can be made thin.

According to one embodiment, the coil is suspended within the groove 630, and vacuum can be maintained inside the groove. According to another embodiment, insulating resin 635 is poured inside the groove over the coil. In either embodiment, positive pressure can be created in the space between the upper and lower plate by injecting gas, such as argon or nitrogen, using fluid conduits made in the back metallic plate. Also, fluid channels may be made in the metallic backplate for thermal control. Magnetic shield can be positioned in the groove over the coil.

While the invention has been described with reference to particular embodiments thereof, it is not limited to those embodiments. Specifically, various variations and modifications may be implemented by those of ordinary skill in the art without departing from the invention's scope, as defined by the appended claims. For example, the embodiment are described with respect to "ceiling"; however, it should be understood that the embodiments may be used in any situation where RF energy is coupled to plasma chamber via dielectric window.

### List of reference signs

- 100: vacuum chamber
- 105: pedestal
- 110: substrate
- 115: coil
- 120: dielectric window
- 125: generator
- 200: chamber
- 205: pedestal
- 210: substrate
- 215: coil
- 220: ceiling
- 225: RF
- 230: groove
- 235: epoxy filling
- 315: coil
- 322: backplate
- 324: dielectric window
- 330: groove
- 335: insulating material
- 340: insulating material
- 345: cover
- 350: bracket
- 415: coil
- 422: ceiling
- 424: dielectric plates
- 430: groove
- 435: insulating material
- 440: insulating material
- 445: cover
- 515: coil
- 522: backplate
- 524: dielectric window
- 530: groove
- 535: insulating material
- 540: insulating material
- 545: cover
- 555: seal
- 560: inlet
- 570: fluid inlet
- 575: outlet
- 615: coil
- 622: metal backplate
- 624: dielectric window / dielectric plate
- 630: groove
- 635: insulating resin

## Claims

1. An RF applicator for an inductively-coupled plasma chamber, comprising:
a dielectric plate having a groove formed therein;
an RF coil positioned inside the groove; and,
insulating resin provided in the groove over the coil.

2. The RF applicator of claim 1, wherein the groove is provided on an upper part of the plate, such that the coil is positioned in atmospheric environment; or wherein the groove is provided on a bottom part of the plate, such that the coil is positioned in vacuum environment.

3. The RF applicator of claim 1, further comprising a metallic backplate attached to upper surface of the dielectric plate, and preferably further comprising magnetic shield positioned in the groove over the coil.

4. The RF applicator of claim 3, further comprising fluid conduit leading to space between the dielectric plate and the metallic backplate, enabling injection of gas into the space to generate positive pressure between the dielectric plate and the metallic backplate.

5. The RF applicator of claim 3, further comprising fluid conduit within the metallic backplate, enabling injection of thermal control fluid inside the metallic backplate to thereby control the temperature of the metallic backplate.

6. An RF applicator for an inductively-coupled plasma chamber, comprising:
a metallic backplate having a groove formed therein;
an RF coil positioned inside the groove;
a dielectric plate attached to the backplate and covering the groove; and,
insulating resin provided in the groove.

7. The RF applicator of claim 6, wherein the groove is provided on a bottom part of the backplate, such that the coil is positioned in vacuum environment;the RF applicator preferably further comprising magnetic shield positioned in the groove over the coil.

8. The RF applicator of claim 7, further comprising fluid conduit leading to space between the dielectric plate and the metallic backplate, enabling injection of gas into the space to generate positive pressure between the dielectric plate and the metallic backplate.

9. The RF applicator of claim 7, further comprising fluid conduit within the metallic backplate, enabling injection of thermal control fluid inside the metallic backplate to thereby control the temperature of the metallic backplate.

10. The RF applicator of claim 7, wherein the insulating resin is provided between the coil and the shield, between the shield and the backplate, or both.

11. A method for fabricating RF power applicator for plasma chamber, comprising:
fabricating a metallic backplate;
forming a groove on bottom surface of the backplate;
inserting an RF radiator into the groove;
fabricating a dielectric plate;
attaching the dielectric plate to the bottom surface of the backplate so as to cover the groove; and preferably further comprising pouring isolation resin into the groove.

12. The method of claim 11, further comprising fabricating a magnetic shield and inserting the magnetic shield into the groove over the radiator.

13. The method of claim 12, further comprising drilling gas conduits in the backplate to enable gas injection to the bottom surface of the backplate into space between the bottom surface of the backplate and upper surface of the dielectric plate; and preferably further comprising drilling gas conduits in the backplate to enable gas injection into the groove.

14. The method of claim 12, further comprising drilling fluid conduits within the backplate to enable circulation of temperature control fluid inside the backplate.

15. The method of claim 11, wherein the dielectric plate comprises a plurality of dielectric wi ndows.
